# EUROPEAN PATENT APPLICATION

(11) **EP 3 229 338 A2**
(43) Date of publication of application: **11.10.2017**
(21) Application number: 17164867.8
(22) Date of filing: 04.04.2017
(51) Int. Cl.: H02J 7/00, H02J 7/04

(54) **ELECTRONIC SYSTEM AND CHARGING METHOD**

(30) Priority: 08.04.2016 US 201662319806 P; 29.03.2017 US 201715473562
(71) Applicant: HTC Corporation, Taoyuan City 330 (TW)
(72) Inventor: LI, Chi-Sheng, 330, Taoyuan District, Taoyuan City (TW); LEE, Hsin-Hao, 330, Taoyuan District, Taoyuan City (TW); WU, Chuan-Li, 330, Taoyuan District, Taoyuan City (TW); LIN, Shih-Ping, 330, Taoyuan District, Taoyuan City (TW); HE, Kun-Da, 330, Taoyuan District, Taoyuan City (TW); CHANG, Chih-Hsiung, 330, Taoyuan District, Taoyuan City (TW); LIN, Kun-wei, 330, Taoyuan District, Taoyuan City (TW)
(74) Representative: Emde, Eric

(57) **Abstract**

An electronic system and a charging method are provided. The electronic system includes an electronic device and a charger. The charger is coupled to the electronic device. The electronic device senses a first state of the electronic device. The electronic device determines whether a value corresponding to the first state is greater than a first threshold. When the value corresponding to the first state is greater than the first threshold, the electronic device provides a first control signal, and the charger charges the electronic device by using a first mode according to the first control signal. When the value corresponding to the first state is not greater than the first threshold, the electronic device provides a second control signal, and the charger charges the electronic device by using a second mode according to the second control signal.

## Description

### CROSS-REFERENCE TO RELATED APPLICATION

This application claims the priority benefits of U.S. provisional application serial no. 62/319,806, filed on April 8, 2016. The entirety of the above-mentioned patent application is hereby incorporated by reference herein and made a part of this specification.

### BACKGROUND OF THE INVENTION

### [Field of the Invention]

The invention relates to an electronic system and a charging method applicable to the electronic system.

### [Description of Related Art]

Currently, almost all electronic devices in the market use rechargeable batteries as power supply. One of the most common types of the rechargeable batteries is lithium batteries, which include lithium ion batteries and lithium polymer batteries, among others. During operation of an electronic device, the electronic device may be connected to a charger to convert an alternating current into a direct current and/or generate a voltage compatible with the electronic device. Then, the power from the charger charges the battery or supplies power to components in the electronic device.

In the prior art, a state of the electronic device is not considered during charging. The state refers to, for example, a temperature of the electronic device, an impedance of a charging cable, a load of a processor, etc. However, during charging, it is very likely that these states may affect charging efficiency or lifetime of the battery.

### SUMMARY OF THE INVENTION

In light of the above, the invention provides an electronic system and a charging method for charging an electronic device by using different modes according to variations in a state of the electronic device. Accordingly, the electronic device is rapidly charged and the user is provided with a more desirable experience.

The invention provides an electronic system. The electronic system includes an electronic device and a charger. The charger is coupled to the electronic device. The electronic device senses a first state of the electronic device. The electronic device determines whether a value corresponding to the first state is greater than a first threshold. The electronic device provides a first control signal when the value corresponding to the first state is greater than the first threshold, and the charger charges the electronic device by using a first mode according to the first control signal. The electronic device provides a second control signal when the value corresponding to the first state is not greater than the first threshold, and the charger charges the electronic device by using a second mode according to the second control signal.

The invention provides a charging method applicable to an electronic system including an electronic device and a charger. The charging method includes: sensing a first state of the electronic device through the electronic device; determining whether a value corresponding to the first state is greater than a first threshold through the electronic device; providing a first control signal through the electronic device when the value corresponding to the first state is greater than the first threshold, and charging the electronic device by using a first mode according to the first control signal through the charger; and providing a second control signal through the electronic device when the value corresponding to the first state is not greater than the first threshold, and charging the electronic device by using a second mode according to the second control signal through the charger.

In light of the above, the electronic system and the charging method of the invention adopt different modes to charge the electronic device according to variations in the state of the electronic device. Accordingly, the electronic device is rapidly charged and the user is provided with a more desirable experience.

To provide a further understanding of the aforementioned and other features and advantages of the invention, exemplary embodiments, together with the reference drawings, are described in detail below.

### BRIEF DESCRIPTION OF THE DRAWINGS

FIG. 1 is a flowchart illustrating a charging method according to an embodiment of the invention.
FIG. 2 is a schematic diagram illustrating an electronic system according to an embodiment of the invention.
FIG. 3 is a flowchart illustrating a charging method according to an embodiment of the invention.
FIG. 4 is a schematic diagram illustrating an electronic system according to an embodiment of the invention.
FIG. 5 is a flowchart illustrating a charging method according to an embodiment of the invention.
FIG. 6A is a schematic diagram illustrating an electronic system according to an embodiment of the invention.
FIG. 6B is a schematic diagram illustrating an electronic system according to an embodiment of the invention.
FIG. 7 is a schematic diagram illustrating performance of a charging method of the invention according to an embodiment of the invention.

### DESCRIPTION OF THE EMBODIMENTS

Reference will now be made in detail to the exemplary embodiments of the disclosure, examples of which are illustrated in the accompanying drawings. Wherever possible, the same reference numbers are used in the drawings and the embodiments to refer to the same or like parts.

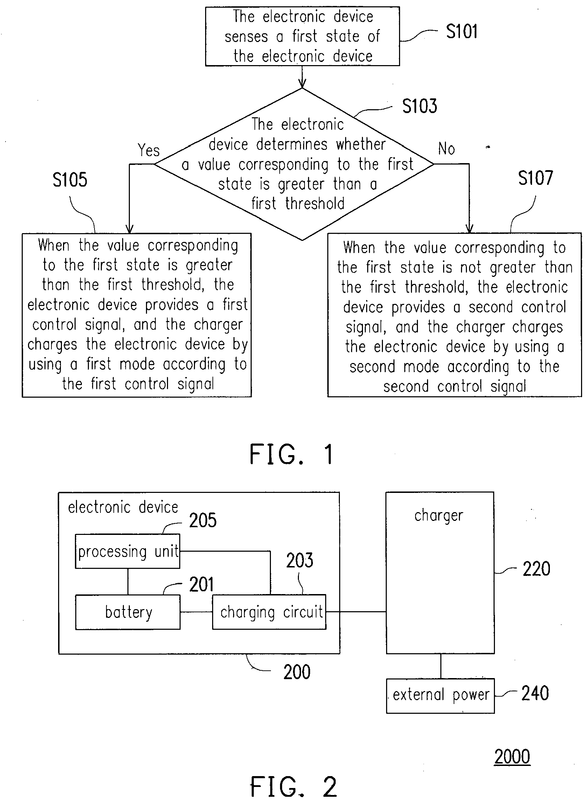

FIG. 1 is a flowchart illustrating a charging method according to an embodiment of the invention. The charging method of FIG. 1 is applicable to an electronic system including an electronic device and a charger.

Referring to FIG. 1, when an electronic device is coupled to a charger, in step S101, the electronic device senses a first state of the electronic device itself. In step S103, the electronic device determines whether a value corresponding to the first state is greater than a first threshold. When the value corresponding to the first state is greater than the first threshold, in step S105, the electronic device provides a first control signal, and the charger charges the electronic device by using a first mode according to the first control signal. Moreover, when the value corresponding to the first state is not greater than the first threshold, in step S107, the electronic device provides a second control signal, and the charger charges the electronic device by using a second mode according to the second control signal.

The electronic system and the charging method of the invention are described below in a plurality of embodiments.

### [First Exemplary Embodiment]

FIG. 2 is a schematic diagram illustrating an electronic system according to an embodiment of the invention.

Referring to FIG. 2, an electronic system 2000 includes an electronic device 200, a charger 220, and an external power 240. The electronic device 200 is a device such as a mobile phone, a personal digital assistant (PDA), a tablet computer, a wireless device, a wearable device, a watch, a portable electronic device, a handheld electronic device, a laptop, etc. The charger 220 is, for example, a power adapter. When the charger 220 is coupled to the electronic device 200 and the external power 240, the charger 220 converts an alternating current provided by the external power 240 into a direct current and charges the electronic device 200.

The electronic device 200 includes a battery 201, a charging circuit 203, and a processing unit 205. The charging circuit 203 is coupled to the battery 201. The processing unit 205 is coupled to the battery and the charging circuit 203. Moreover, the charging circuit 203 is coupled to the charger 220 via a charging cable.

The battery 201 is a lithium battery or a rechargeable battery of another type.

The charging circuit 203 is a circuit adapted to convert a voltage provided by the charging cable into an adequate voltage for charging the battery 201.

The processing unit 205 is, for example, a central processing unit (CPU), a processor, a microprocessor, or an embedded controller (EC) of the electronic device 200.

Generally, in the case where the electronic device is charged by using a voltage-adjustable high-wattage charger with a charging cable that does not conform to a nominal impedance, when the battery of the electronic device is in a low-power state, the voltage outputted by the charger is erroneously determined as a boost voltage due to the excessively high impedance of the charging cable. In this case, the charging circuit of the electronic device is caused to stop charging the battery due to the high voltage.

To solve the issue that charging of the battery stops due to the excessively high impedance of the charging cable, in the present exemplary embodiment of the invention, the charger 220 is a voltage-adjustable high-wattage charger. Particularly, the charger 220 simultaneously supports specifications such as Quick Charge 2.0 (QC 2.0) and Quick Charge 3.0 (QC 3.0) and charges the electronic device 200 by using one of Quick Charge 2.0 and Quick Charge 3.0 according to the impedance of the charging cable.

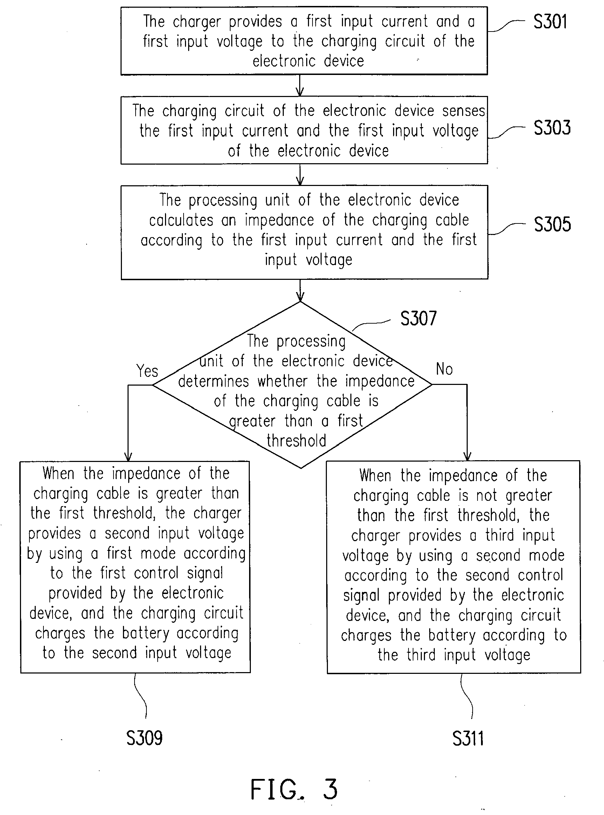

Specifically, FIG. 3 is a flowchart illustrating a charging method according to an embodiment of the invention. The charging method of FIG. 3 is applicable to the electronic system 2000 of FIG. 2.

Referring to both FIG. 2 and FIG. 3, in an early stage of charging, when the charger 220 is connected to the external power 240 and is connected (or coupled) to the electronic device 200 via the charging cable, the charger 220 converts an alternating current provided by the external power 240 into a direct current, and provides a first input current and a first input voltage to the charging circuit 203 of the electronic device 200 (step S301). Then, the charging circuit 203 of the electronic device 200 senses a first state of the electronic device 200, and the first state is the first input current and the first input voltage received by the charging circuit 203 (step S303).

Next, the processing unit 205 calculates an impedance of the charging cable according to the first input current and the first input voltage (step S305). The calculation of the impedance according to the current and the voltage may be learned from the prior art and is thus not repeatedly described here. Afterwards, the processing unit 205 determines whether the impedance of the charging cable is greater than a first threshold (step S307). Particularly, an optimal value of the first threshold is obtained through experiments, and the invention does not intend to limit the value of the first threshold.

When the impedance of the charging cable calculated by the processing unit 205 is greater than the first threshold, the processing unit 205 of the electronic device 200 provides a first control signal to the charger 220. The charger 220 provides a second input voltage by using a first mode according to the first control signal, and the charging circuit 203 charges the battery 201 according to the second input voltage (step S309).

In the present exemplary embodiment, the first mode is Quick Charge 2.0. Generally, the standard of Quick Charge 2.0 predetermines a plurality of discontinuous default voltages, and the default voltages are fixed voltages (e.g., four voltages including 5V, 9V, 12V, and 20V). According to the first control signal, the charger 220 selects one voltage among the foregoing discontinuous default voltages as the second input voltage. For example, the charger 220 selects 5V as the second input voltage for charging the electronic device 200.

However, when the impedance of the charging cable calculated by the processing unit 205 is not greater than the first threshold, the processing unit 205 of the electronic device 200 provides a second control signal to the charger 220. The charger 220 provides a third input voltage by using a second mode according to the second control signal, and the charging circuit 203 charges the battery 201 according to the third input voltage (step S311).

In the present exemplary embodiment, the second mode is Quick Charge 3.0. Generally, the standard of Quick Charge 3.0 predetermines one continuous voltage interval, e.g., a voltage interval in a range of 3.6V to 20V. The processing unit 205 determines a voltage in the voltage interval to be the third input voltage (e.g., 3.9V) according to the first input current and provides the second control signal to the charger 220. Then, the charger 220 selects 3.9V in the continuous voltage interval as the third input voltage according to the second control signal. The charger 220 charges the electronic device 200 by using the third input voltage.

By the design described above, the electronic system and the charging method of the first embodiment of the invention are capable of rapidly and accurately calculating the impedance. When the impedance of the charging cable is excessively high, the charger 220 is controlled to output a corresponding voltage to allow the electronic device 200 to continue to quick charge. Accordingly, the issue that the electronic device 200 cannot charge due to the excessively high impedance of the charging cable is completely avoided, and user's experience and perception are improved.

### [Second Exemplary Embodiment]

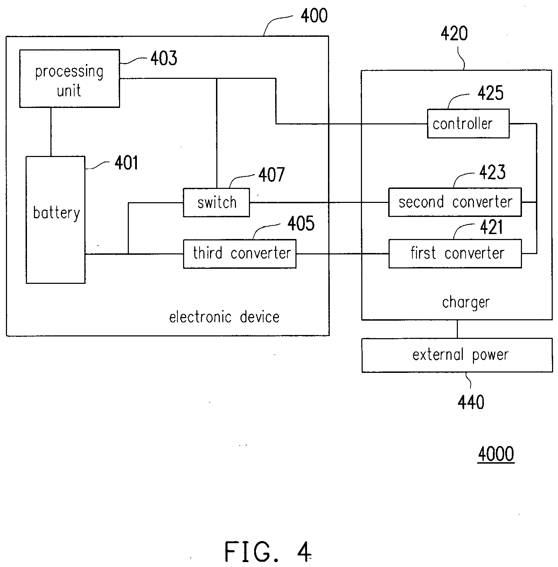

FIG. 4 is a schematic diagram illustrating an electronic system according to an embodiment of the invention.

Referring to FIG. 4, an electronic system 4000 includes an electronic device 400, a charger 420, and an external power 440. The electronic device 400 is a device such as a mobile phone, a personal digital assistant (PDA), a tablet computer, a wireless device, a wearable device, a watch, a portable electronic device, a handheld electronic device, a laptop, etc. The charger 420 is, for example, a power adapter. When the charger 420 is coupled to the electronic device 400 and the external power 440, the charger 420 converts an alternating current provided by the external power 440 into a direct current and charges the electronic device 400.

In the present exemplary embodiment, the electronic device 400 includes a battery 401, a processing unit 403, a third converter 405, and a switch 407. The third converter 405 and the switch 407 are respectively coupled to the battery 401. The processing unit 403 is coupled to the battery 401, the switch 407, and the third converter 405. For clarity, FIG. 4 does not illustrate the coupling relationship between the processing unit 403 and the third converter 405. Moreover, the battery 401 and the processing unit 403 are respectively components that are similar to the foregoing battery 201 and the processing unit 205 and are thus not repeatedly described here.

The third converter 405 is a converter adapted to convert a voltage and a current from the charger 420 into adequate voltage and current for charging the battery 401.

The switch 407 is, for example, a switch circuit. The switch circuit is, for example, a MOSFT switch or a switch of another type that is switchable between an on-state and an off-state according to a control signal.

The charger 420 includes a first converter 421, a second converter 423, and a controller 425. The controller 425 is coupled to the first converter 421 and the second converter 423. The controller 425 is a component that is similar to the foregoing processing unit 205 and is thus not repeatedly described here.

The first converter 421 and the second converter 423 are converters adapted to convert an alternating current from the external power 440 into a direct current to supply power to the electronic device 400 for charging. Particularly, the controller 425 is switchable between the first converter 421 and the second converter 423. In other words, the controller 425 may select to use the first converter 421 to provide a direct current to the electronic device 400 or use the second converter 423 to provide a direct current to the electronic device 400. Specifically, the direct current provided by the first converter 421 and the direct current provided by the second converter 423 are different from each other. For example, the controller 425 uses the first converter 421 to convert a power provided by the external power 440 into 5V and 2A and provides the converted power to the electronic device 400. However, the controller 425 may also use the second converter 421 to convert the power of the external power 440 into 3.6V and 2.5A and provide the converted power to the electronic device 400.

When the charger 420 is coupled to the electronic device 400 via the charging cable, the first converter 421 of the charger 420 is coupled to the third converter 405 of the electronic device 400, the second converter 405 of the charger 420 is coupled to the switch 407 of the electronic device 400, and the controller 425 of the charger 420 is coupled to the processing unit 403 of the electronic device 400.

When the controller 425 is coupled to the electronic device 400 via the charging cable, the electronic device 400 senses that the charger 420 connected thereto includes at least two converters (i.e., the first converter 421 and the second converter 423). The processing unit 403 of the electronic device 400 controls switching between the first converter 421 and the second converter 423 according to a state of the electronic device 400 in use (during charging).

In the present exemplary embodiment, when the switch 407 of the electronic device 400 is in an opened-state, a path (also referred to as a second path) formed by the second converter 423 and the switch 407 is in an off-state. The charger 420 charges the battery 401 through a path (also referred to as a first path) formed by the first converter 421 and the third converter 405. For example, the first converter 421 of the charger 420 first converts the power of the external power 440 into 5V/2A or 9V/1.67A. Then, the power of 5V/2A or 9V/1.67A is converted by the third converter 405 to further convert 5V/2A or 9V/1.67A into a voltage that is appropriate for charging the battery 401 using 3A.

Moreover, when the switch 407 of the electronic device 400 is in an closed-state, the second path formed by the second converter 423 and the switch 407 is in an on-state. The charger 425 uses the second path formed by the second converter 423 and the switch 407 to charge the battery 401. For example, the second converter 423 of the charger 420 first converts the power of the external power 440 into a voltage of 3.6V to 5.2V and 2.5A. Then, the power converted by the second converter 423 is directly provided to the battery 401 via the switch 407 to charge the battery 401. In other words, the electronic device 400 does not further convert the power received from the charger 420.

Supposing that in an initial state, the switch 407 of the electronic device 400 is in the opened-state. When the electronic device 400 is connected to the charger 420, the charger 420 uses the first path formed by the first converter 421 and the third converter 405 to charge the battery 401. At this time, the charger 420 provides a higher current to the electronic device 400. It shall be noted here that the foregoing method of charging using the first path may be referred to as a "second mode", and the foregoing method of charging using the second path may be referred to as a "first mode".

It shall be noted that during charging using the first path, when the third converter 405 converts the power from the charger 420 into a voltage or current desired by the electronic device 400, part of the power may be lost and converted into heat. At this time, a temperature of the third converter 405 rises. When the temperature of the third converter 405 increases, the electronic device 400 may overheat. Moreover, when the processing unit 403 processes a great amount of data, uses different sensors to sense the environment, or uses an antenna to transmit data, these operations all cause a temperature of the electronic device 400 to rise. In the present exemplary embodiment, when the electronic device 400 uses the first path formed by the first converter 421 and the third converter 405 to charge the battery 401, the processing unit 403 determines whether the electronic device 400 overheats or is to overheat. When the electronic device 400 overheats or is to overheat, the processing unit 403 sends a control command to turn off the switch 407 and instructs the controller 425 to switch from the first converter 421 to the second converter 423. Afterwards, the charger 420 charges the battery 401 via the second path. Accordingly, the third converter 405 is prevented from constantly generating heat and causing the temperature of the electronic device 400 to continue to rise.

Here, the determination on whether the device is to overheat may be based on comprehensive evaluations of the following: whether the electronic device 400 turns on a plurality of specific components, e.g., a GPS sensor, WIFI, a 3G or 4G Internet antenna, a Bluetooth antenna, a camera, an ultrasonic transmitter, a radar transmitter, a current output device, etc.; or whether a memory usage rate exceeds a predetermined value (e.g., the memory usage rate exceeds 70%), or a specific application (e.g., Facebook application, a map application, a game application, a camera application, etc.) is turned on. The determination method may be different combinations of the foregoing determination criteria (e.g., when the camera application and the GPS sensor are simultaneously turned on). The foregoing different determination criteria or the combinations thereof are used to predict whether the electronic device 400 will have the issue of overheating some time in the future, so that different charging methods can be used during charging. The determination criteria may additionally apply with different sensors (e.g., a temperature sensor provided close to the processing unit 403, a memory unit, or a battery unit) to sense a current state of the electronic device 400. Based on the current state of the electronic device 400, the foregoing determination criteria are used to determine whether the electronic device 400 will have the issue of overheating some time in the future.

The foregoing determination criteria or the combinations thereof may be stored in a memory. During charging, the processing unit 403 reads data stored in the memory. The processing unit 403 determines whether to perform the switching based on the stored data. The processing unit 403 also determines whether the electronic device 400 will have the issue of overheating some time in the future and sets a time point for switching the charging method. For example, the temperature sensor provided on the processing unit 403 senses that the processing unit 403 is 100 degrees (°C) and the GPS sensors is activated for operation, and the activation of the GPS sensor causes the temperature of the electronic device 400 to rise by 10 degrees every 10 minutes. If the processing unit 403 sets that adjustment has to be made at 110 degrees, the processing unit 403 may be set to automatically switch the charging method 9 minutes later to prevent the processing unit 403 from exceeding a working temperature. Conversely, for example, if the temperature sensor provided on the processing unit 403 senses that the processing unit 403 is 110 degrees but the GPS sensor has stopped operating, and the deactivation of the GPS sensor causes the temperature of the electronic device 400 to drop by 10 degrees every 10 minutes, the processing unit 403 may be set to switch to a charging mode that generates higher heat within a predetermined time.

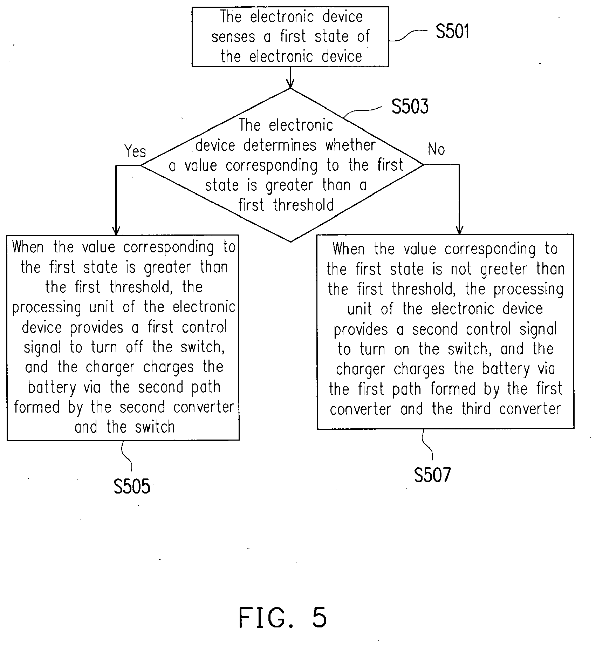

FIG. 5 is a flowchart illustrating a charging method according to an embodiment of the invention. The charging method of FIG. 5 is applicable to the electronic system 4000 of FIG. 4.

Referring to both FIG. 4 and FIG. 5, in the present exemplary embodiment, when the charger 420 is coupled to the electronic device 400 and the external power 440, the electronic device 400 senses a first state of the electronic device 400 (step S501). Then, the electronic device 400 determines whether a value corresponding to the first state is greater than a first threshold (step S503). When the value corresponding to the first state is greater than the first threshold, the processing unit 403 provides a first control signal to turn off the switch 407, and the charger 420 charges the battery 401 via the second path formed by the second converter 423 and the switch 407 (step S505). When the value corresponding to the first state is not greater than the first threshold, the processing unit 403 provides a second control signal to turn on the switch 407, and the charger 420 charges the battery 401 via the first path formed by the first converter 421 and the third converter 405 (step S507).

Particularly, in the present exemplary embodiment, a default state of the electronic device 400 is charging by using the first path (i.e., the switch 407 is in the opened-state). When the electronic device 400 switches to use the second path for charging, the electronic device 400 continues to sense the first state. When the value corresponding to the first state is lower than the threshold, the electronic device 400 switches back to use the first path for charging. However, in an exemplary embodiment, when the electronic device 400 switches to use the second path for charging, the electronic device 400 may also use the second path only for charging until the power of the battery 401 is fully charged.

It shall be noted here that the first state may be a temperature of some one component in the electronic device 400 or an overall temperature of the electronic device 400 itself. The processing unit 403 senses the temperature of the electronic device 400 or the specific component by using a plurality of methods. For example, the processing unit 403 is coupled to a temperature sensor to sense a temperature of multiple positions or specific positions. The positions are, for example, a position of the processing unit 403, a position of the battery 401, or a position of a communication unit (not illustrated). When the processing unit 403 determines that the sensed temperature is higher than the threshold, the processing unit 403 provides the first control signal to turn off the switch 407 and charges the battery 401 via the second path. Otherwise, the processing unit 403 provides the second control signal to turn on the switch 407 to charge the battery 401 via the first path. Particularly, in the second path, since the electronic device 400 does not need to further convert the current and the voltage outputted by the second converter 423, the temperature of the electronic device 400 is effectively controlled to stop rising.

Moreover, the first state may also be the heat that may be generated by the electronic device 400 in the future. The processing unit 403 determines the heat that may be generated by the electronic device 400 in the future according to the sensors used or activated by the electronic device 400. It is known that when some sensors or circuits are activated, a great amount of heat is generated. For example, a user may use a positioning unit (not illustrated, e.g., a GPS module) to sense a position of the user or the electronic device 400. When the positioning unit is activated for a period of time, the processing unit 403 determines that the heat generated by the positioning unit will affect future use of the electronic device 400. In addition, the communication unit (e.g., a WiFi module) and an image capturing unit (e.g., a camera module) may also be determined to be components that generate heat. A total heat of each of the foregoing components may be considered by weighting, for example, to generate a corresponding value and further determine whether it is necessary to turn off the switch 407 to directly charge the battery 401 via the second path. When the processing unit 403 determines that the heat is greater than the threshold, the processing unit 403 provides the first control signal to turn off the switch 407 to charge the battery 401 via the second path. Otherwise, the processing unit 403 provides the second control signal to turn on the switch 407 to charge the battery 401 via the first path. However, the invention does not intend to limit how the heat of the electronic device is calculated. Moreover, the invention may also determine whether it is necessary to turn off the switch 407 to charge the battery 401 via the second path solely based on the heat that may be generated by one single component or part of the components in the future.

Furthermore, the first state may also be a load of the electronic device 400. The load of the electronic device 400 may be determined according to a current consumed by the electronic device 400. For example, the processing unit 403 uses a current sensor (not illustrated) to monitor the current consumed by the electronic device 400. The current sensor is, for example, provided in the processing unit 403, the battery 401, or the communication unit (not illustrated). When the processing unit 403 senses that the current consumed by the electronic device 400 is greater than 400mA, the processing unit 403 provides the first control signal to turn off the switch 407 to charge the battery 401 via the second path. Otherwise, the processing unit 403 provides the second control signal to turn on the switch 407 to charge the battery 401 via the first path.

In addition, the first state may also be a state of the battery 401. The processing unit 403 or the charging circuit of the electronic device 400 senses the state of the battery 401 (e.g., a state value corresponding to a voltage, a battery capacity, or a charging state). Based on the foregoing state value regarding the battery 401, the processing unit 403 also correspondingly changes the path for charging.

Moreover, the first state may also be a protection mechanism of the electronic device 400. The processing unit 403 or the charging circuit of the electronic device 400 senses an over voltage protection (OVP), an over power protection (OPP), an over load protection (OLP), or an over current protection (OCP), and determines whether the foregoing protection mechanisms occur according to corresponding reference values. Based on the occurrence of the foregoing protection mechanisms, the processing unit 403 also correspondingly changes the path for charging.

The foregoing method mainly involves using hardware components to sense the first state of the electronic device to obtain the value corresponding to the first state. However, the first state may also be sensed by using software. For example, the processing unit 403 determines the heat generated by a loading or operating software program. The software program is, for example, a map service program, a game program, a camera program, a video-recording program, social networking software, etc. When the foregoing software programs are loaded or executed, they may consume more power and generate more heat. Particularly, software that turns on specific components is all software that easily generates heat. Such software is, for example, the foregoing map program, cameral program, video-recording program, etc. When the processing unit 403 determines that the foregoing software is turned on, the processing unit 403 provides the first control signal to turn off the switch 407 to charge the battery 401 via the second path. When the processing unit 403 determines that the software is turned off, the processing unit 403 provides the second control signal to turn on the switch 407 to charge the battery 401 via the first path.

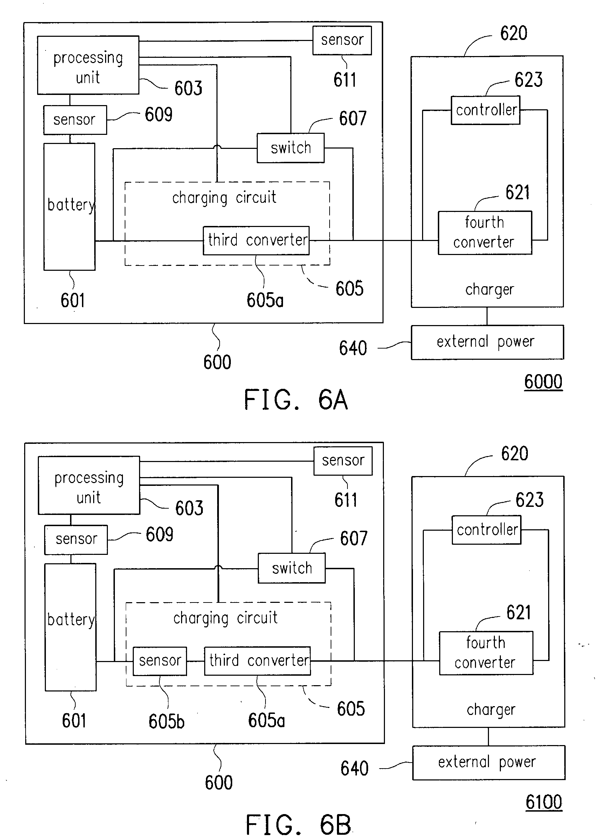

Furthermore, the charging method of FIG. 5 is applicable to electronic systems of other different configurations. For example, FIG. 6A is a schematic diagram illustrating an electronic system according to an embodiment of the invention.

Referring to FIG. 6A, an electronic system 6000 includes an electronic device 600, a charger 620, and an external power 640. In the present exemplary embodiment, the electronic device 600 includes a battery 601, a processing unit 603, a charging circuit 605, a switch 607, a sensor 609, and a sensor 611. The charging circuit 605 and the switch 607 are respectively coupled to the battery 601. The battery 601 is coupled to the sensor 609. The processing unit 603 is coupled to the charging circuit 605, the switch 607, the sensor 609, and the sensor 611. The battery 601, the processing unit 603, and the switch 607 are respectively components that are similar to the foregoing battery 201, processing unit 205, and switch 407 and are thus not repeatedly described here.

In the present exemplary embodiment, the charging circuit 605 further includes a third converter 605a. The third converter 605a is adapted to execute a function similar to that of the foregoing third converter 405.

The sensor 609 is provided between the processing unit 603 and the battery 601 to measure a power provided by the battery 601 to the processing unit 609. The sensor 611 is, for example, a temperature sensor or a sensor of another function, e.g., a camera, an optic sensor, a proximity sensor, etc.

Moreover, the processing unit 603 also includes a sensor (not illustrated) therein. The sensor senses a load of the processing unit 603 or the temperature sensor to sense a heat in the processing unit 603 or the electronic device 600.

The charger 620 includes a controller 623 and a fourth converter 621. The fourth converter 621 includes the first converter 421 and the second converter 423 of FIG. 4 or simultaneously has the functions of the first converter 421 and the second converter 423. The controller 623 controls the fourth converter 621 to convert a power of the external power 640 into a different power to provide power to the third converter 605a of the charging circuit 605 or the switch 607 to charge the battery 601. In other words, the fourth converter 621 and the third converter 605a form the foregoing first path, and the fourth converter 621 outputs the converted voltage and current to the third converter 605a to charge the battery 601 via the first path; alternatively, the fourth converter 621 and the switch 607 form the foregoing second path, and the fourth converter 621 outputs the current and voltage to charge the battery 601 via the second path formed by the fourth converter 621 and the switch 607. Particularly, in the second path, since the electronic device 600 does not need to further convert the current and the voltage outputted by the fourth converter 621, a temperature of the electronic device 600 is effectively controlled to stop rising.

Moreover, the electronic device 600 of FIG. 6A may further include other components. For example, FIG. 6B is a schematic diagram illustrating an electronic system according to an embodiment of the invention.

Referring to FIG. 6B, an electronic system 6100 of FIG. 6B is substantially identical to the electronic system 6000 of FIG. 6A. The only difference is that the charging circuit 605 of FIG. 6B includes a sensor 605b coupled to the third converter 605a and the battery 601. The sensor 605b is adapted to sense a current or voltage provided to the battery. It shall be noted here that FIG. 6A and FIG. 6B only illustrate the electronic systems that are applicable to the charging method of FIG. 5. However, the invention is not limited hereto. In other exemplary embodiments, the electronic system applicable to the charging method of FIG. 5 may include more or less components.

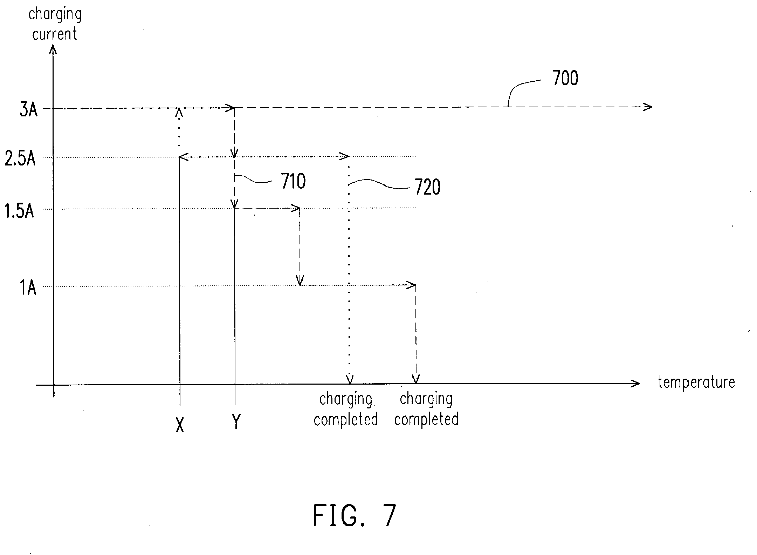

FIG. 7 is a schematic diagram illustrating performance of a charging method of the invention according to an embodiment of the invention.

Referring to FIG. 7, FIG. 7 illustrates the switching between the first path and the second path during charging. In the initial state, when the charger is connected to the electronic device, the charger outputs a power having a high current (e.g., 3A) via the first path to the electronic device. This power is converted by the first converter in the first path. During charging, the third converter in the electronic device generates heat due to power conversion. When the charging of the battery continues, the temperature of the electronic device constantly rises.

In a conventional converter, as a line segment 700 shows, as the temperature rises, the converter in the conventional charger can continually provide the maximum current (i.e., 3A as indicated above). At this time, the converter in the electronic device may generate more heat, causing the temperature of the electronic device to constantly rise. Alternatively, in the conventional converter, as a line segment 710 shows, when the temperature rises to a value Y, the converter of the charger lowers the outputted current to reduce the heat generated by the converter of the electronic device. However, since the same converter in the electronic device is invariably used in the line segment 710 to charge the battery, when the converter is continually used for charging, the converter still causes the temperature of the electronic device to continue to rise.

In the charging method of the invention, when switched to the second path to charge the electronic device, the switch of the electronic device does not convert the power inputted to the electronic device. In other words, this method removes the heat generated by the converter (i.e., the foregoing first converter) in the electronic device. As a line segment 720 shows, the charger uses the first path to output a power of a high current (e.g., 3A) to the electronic device. The electronic device uses the first converter to convert the power of the higher current. As the temperature rises to a threshold (e.g., the value Y), the first converter is disabled. The charger turns off the switch to charge the battery via the second path without passing the first converter in the first path. At this time, since the first converter is disabled, the first converter does not continue to generate heat. When the temperature of the electronic device drops to a specific temperature (e.g., a value X), the electronic device switches back to the first path to continue to charge in a high current (e.g., 3A). Specifically, the charger may also continue to use the second path to charge the battery until the battery is fully charged. However, the charger may also constantly switch between the first path and the second path during charging until the battery is fully charged. As FIG. 7 shows, compared to the conventional charger, the charging method of the invention more rapidly completes the charging and effectively inhibits rise in the temperature of the electronic device.

In particular, the first exemplary embodiment and the second exemplary embodiment of the invention may be combined with each other. For example, in the initial state, when the electronic device is connected to the charger via the charging cable, an impedance of the charging cable is first determined to determine whether to use Quick Charge 2.0 or Quick Charge 3.0 for charging. Afterwards, during charging, the electronic device may constantly sense the first state of the electronic device itself to determine whether to use the first path or the second path for charging.

In summary of the above, the electronic system and the charging method of the invention adopt different modes to charge the electronic device according to the variations in the state of the electronic device. Accordingly, the electronic device is rapidly charged and the user is provided with a more desirable experience.

Although the invention is disclosed as the embodiments above, the embodiments are not meant to limit the invention. Any person skilled in the art may make slight modifications and variations without departing from the spirit and scope of the invention. Therefore, the protection scope of the invention shall be defined by the claims attached below.

## Claims

1. An electronic system comprising:
an electronic device; and
a charger coupled to the electronic device, wherein
the electronic device senses a first state of the electronic device,
the electronic device determines whether a value corresponding to the first state is greater than a first threshold,
the electronic device provides a first control signal when the value corresponding to the first state is greater than the first threshold, and the charger charges the electronic device by using a first mode according to the first control signal, and
the electronic device provides a second control signal when the value corresponding to the first state is not greater than the first threshold, and the charger charges the electronic device by using a second mode according to the second control signal.

2. The electronic system according to claim 1, wherein the electronic device comprises a battery, a charging circuit, and a processing unit, wherein the charging circuit is coupled to the battery and the processing unit is coupled to the battery and the charging circuit, and the charging circuit is coupled to the charger via a charging cable.

3. The electronic system according to claim 2, wherein
the charger provides a first input current and a first input voltage to the charging circuit,
in the operation of sensing the first state of the electronic device, the charging circuit senses the first input current and the first input voltage, and
in the operation of determining whether the value corresponding to the first state is greater than the first threshold, the processing unit calculates an impedance of the charging cable according to the first input current and the first input voltage and determines whether the impedance of the charging cable is greater than the first threshold.

4. The electronic system according to claim 3, wherein
the charger provides a second input voltage by using the first mode according to the first control signal when the impedance of the charging cable is greater than the first threshold, and the charging circuit charges the battery according to the second input voltage, and
the charger provides a third input voltage by using the second mode according to the second control signal when the impedance of the charging cable is not greater than the first threshold, and the charging circuit charges the battery according to the third input voltage.

5. The electronic system according to claim 4, wherein
in the operation of providing the second input voltage by using the first mode according to the first control signal, the charger selects the second input voltage among a plurality of discontinuous default voltages according to the first control signal.

6. The electronic system according to claim 4, wherein
in the operation of providing the second control signal, the processing unit provides the second control signal according to the first input current, and
in the operation of providing the third input voltage by using the second mode according to the second control signal, the charger selects the third input voltage in a continuous voltage interval according to the second control signal.

7. The electronic system according to claim 1, wherein the first mode is Quick Charge 2.0.

8. The electronic system according to claim 1, wherein the second mode is Quick Charge 3.0.

9. The electronic system according to claim 1, wherein
the charger comprises a first converter, a second converter, and a controller, wherein the controller is coupled to the first converter and the second converter,
the electronic device comprises a battery, a third converter, a switch, and a processing unit, wherein the third converter and the switch are respectively coupled to the battery, and the processing unit is coupled to the battery, the switch, and the third converter, and
the first converter is coupled to the third converter, the second converter is coupled to the switch, and the controller is coupled to the processing unit, when the charger is coupled to the electronic device.

10. The electronic system according to claim 9, wherein
in the operation of providing the first control signal and charging the electronic device by using the first mode according to the first control signal, the processing unit provides the first control signal to turn off the switch, and the charger charges the battery via the second converter and the switch, and
in the operation of providing the second control signal and charging the electronic device by using the second mode according to the second control signal, the processing unit provides the second control signal to turn on the switch, and the charger charges the battery via the first converter and the third converter.

11. The electronic system according to claim 10, wherein the value of the first state comprises one of a temperature of the electronic device, a temperature of at least one component of the electronic device, a heat to be generated by the electronic device, a heat to be generated by at least one component of the electronic device, a current consumed by the electronic device, a state value corresponding to a state of the battery, and a reference value corresponding to a protection mechanism of the electronic device.

12. The electronic system according to claim 9, wherein
the electronic device further comprises a charging circuit comprising the third converter.

13. The electronic system according to claim 9, wherein
the charger further comprises a fourth converter comprising the first converter and the second converter.

14. A charging method applicable to an electronic system comprising an electronic device and a charger, the charging method comprising:
sensing a first state of the electronic device through the electronic device;
determining whether a value corresponding to the first state is greater than a first threshold through the electronic device;
providing a first control signal through the electronic device when the value corresponding to the first state is greater than the first threshold, and charging the electronic device by using a first mode according to the first control signal through the charger; and
providing a second control signal through the electronic device when the value corresponding to the first state is not greater than the first threshold, and charging the electronic device by using a second mode according to the second control signal through the charger.

15. The charging method according to claim 14, wherein the electronic device comprises a battery, a charging circuit, and a processing unit, wherein the charging circuit is coupled to the battery and the processing unit is coupled to the battery and the charging circuit, and the charging circuit is coupled to the charger via a charging cable.

16. The charging method according to claim 15, further comprising:
providing a first input current and a first input voltage to the charging circuit through the charger;
in the step of sensing the first state of the electronic device, sensing the first input current and the first input voltage through the charging circuit; and
in the step of determining whether the value corresponding to the first state is greater than the first threshold, calculating an impedance of the charging cable according to the first input current and the first input voltage through the processing unit, and determining whether the impedance of the charging cable is greater than the first threshold.

17. The charging method according to claim 16, further comprising:
providing a second input voltage by using the first mode according to the first control signal through the charger when the impedance of the charging cable is greater than the first threshold, and charging the battery according to the second input voltage through the charging circuit; and
providing a third input voltage by using the second mode according to the second control signal through the charger when the impedance of the charging cable is not greater than the first threshold, and charging the battery according to the third input voltage through the charging circuit.

18. The charging method according to claim 17, further comprising:
in the step of providing the second input voltage by using the first mode according to the first control signal, selecting the second input voltage among a plurality of discontinuous default voltages according to the first control signal through the charger.

19. The charging method according to claim 17, further comprising:
in the step of providing the second control signal, providing the second control signal according to the first input current through the processing unit; and
in the step of providing the third input voltage by using the second mode according to the second control signal, selecting the third input voltage in a continuous voltage interval according to the second control signal through the charger.

20. The charging method according to claim 14, wherein the first mode is Quick Charge 2.0.

21. The charging method according to claim 14, wherein the second mode is Quick Charge 3.0.

22. The charging method according to claim 14, wherein
the charger comprises a first converter, a second converter, and a controller, wherein the controller is coupled to the first converter and the second converter,
the electronic device comprises a battery, a third converter, a switch, and a processing unit, wherein the third converter and the switch are respectively coupled to the battery, and the processing unit is coupled to the battery, the switch, and the third converter, and
the first converter is coupled to the third converter, the second converter is coupled to the switch, and the controller is coupled to the processing unit, when the charger is coupled to the electronic device.

23. The charging method according to claim 22, further comprising:
in the step of providing the first control signal and charging the electronic device by using the first mode according to the first control signal, providing the first control signal to turn off the switch through the processing unit, and charging the battery via the second converter and the switch through the charger; and
in the step of providing the second control signal and charging the electronic device by using the second mode according to the second control signal, providing the second control signal to turn on the switch through the processing unit, and charging the battery via the first converter and the third converter through the charger.

24. The charging method according to claim 23, wherein the value of the first state comprises one of a temperature of the electronic device, a temperature of at least one component of the electronic device, a heat to be generated by the electronic device, a heat to be generated by at least one component of the electronic device, a current consumed by the electronic device, a state value corresponding to a state of the battery, and a reference value corresponding to a protection mechanism of the electronic device.

25. The charging method according to claim 22, wherein
the electronic device further comprises a charging circuit comprising the third converter.

26. The charging method according to claim 22, wherein
the charger further comprises a fourth converter comprising the first converter and the second converter.
